# EUROPEAN PATENT APPLICATION

(11) **EP 1 933 393 A1**
(43) Date of publication of application: **18.06.2008**
(21) Application number: 06126004.8
(22) Date of filing: 13.12.2006
(51) Int. Cl.: H01L 51/00, H01L 27/32

(54) **Method of manufacturing a substrate for an electronic device**

(71) Applicant: Samsung SDI Co., Ltd., Suwon-si Gyeonggi-do (KR)
(72) Inventor: Mathea, Arthur, 14197, Berlin (DE); Fischer, Joerg, 13053, Berlin (DE); Schaedig, Marcus, 15711, Könings Wusterhausen (DE)
(74) Representative: Hengelhaupt, Jürgen

(57) **Abstract**

The present invention relates to a method of manufacturing a substrate for an electronic device.

An object of the invention is to provide a method of manufacturing a substrate for an electronic device such as a substrate for an OLED display comprising a bank structure requiring a fewer number of processes. Another object of the invention is to provide a direct patterning technique for insulating layers such as fluorinated organic polymers by using cost-efficient techniques such as inkjet printing.

According to the invention a method for manufacturing a substrate for an electronic device comprising at least one structured layer comprising an organic insulating material, the method comprising the following steps: providing a supporting substrate (1); applying a continuous layer (2) comprising an organic insulating material on the supporting substrate (1); and applying an organic solvent (3) directly on the continuous layer (2) of an organic insulating material.

## Description

### FIELD OF THE INVENTION

The present invention relates to a method of manufacturing a substrate for an electronic device, more particularly the present invention relates to a method for manufacturing a substrate comprising a bank structure for an organic light emitting diodes (OLED) display, to a method for insulating conductive lines such as conductive lines used in a pixel circuit of an active matrix OLED device, to a method for manufacturing a thin film transistor (TFT) and insulating a gate electrode of a TFT used in a pixel circuit of an active matrix OLED or an electrophoretic device.

### BACKGROUND OF THE INVENTION

According to the state of the art, there is no convenient process for direct patterning of insulating materials such as fluorinated organic polymers. According to the invention an insulating materials is understood as a material comprising a breakthrough voltage of 2,0 MV/cm or more. Therefore it is desirable to provide a patterning method of insulating materials such as fluorinated organic polymers by using cost-efficient techniques such as inkjet printing.

For example for the manufacture of an OLED display liquid ink containing organic electroluminescent material can be applied into respective pixel areas of the display. However, due to ink wetting issues, a bank structure is needed for many inkjet patterning processes to reach the required pattern, for example to avoid an ink overflow into adjacent pixel areas of the respective OLED display device. However, the manufacture of such a bank structure requires the use of photo resist (photo lithography process) followed by fluorination processes to generate a good working bank which comprises mechanical barriers on the one hand and a pattern of hydrophilic and hydrophobic areas on the other hand. However, the necessity to use such bank structures to avoid ink overflow results in a high number of process steps.

### OBJECT OF THE INVENTION

Therefore one object of the invention is to provide a method for manufacturing a substrate for an electronic device such as a substrate for an OLED display comprising a bank structure requiring a fewer number of processes. Another object of the invention is to provide a direct patterning technique for insulating layers such as fluorinated organic polymers by using cost-efficient techniques such as inkjet printing.

### SUMMARY OF THE INVENTION

The present invention introduces a pattering method where it is simple to produce many convenient structures, which reduce process steps, increase device performance and fill factor of display elements. With the new technique it is possible to fabricate alignment structures for following printing processes e.g. in organic display devices. The reduction of process steps by the use of patterned fluorinated organic polymers as a self alignment (no wetting) layer for following coatings is an additional effect. Furthermore the patterning method according to the invention is roll to roll compatible, therefore flexible substrates are processable.

The idea of the present invention is to apply a solvent (preferably fluorinated solvent) on completely coated surfaces with functional layers e.g. polymers and fluoropolymers, which are used as an insulator or an organic gate dielectric in organic electronics. The solvent is preferably applied by inkjet printing.

The applied solvent is dissolving some insulating material and due to the kinetic energy of the solvent the dissolved material is flowing to the side. The following solvent droplets dissolves more of the insulating material. The generated high concentrated solution has enough kinetic energy to move out of the resulting hole in the insulator. Due to the low boiling point the solvent evaporates very fast, so that the dissolved material becomes solid directly at the edge of the aborning hole.

The applied (printed) solvent is dissolving the insulating material (on the substrate). This results in a hole/ a groove/ a hollowed portion or a recessed portion in the insulating layer in an area onto which the solvent has been applied. Furthermore some material accumulates at an edge portion of an area onto which the solvent is applied and or at an outer portion of the area onto which the solvent is applied. This accumulated material can for example be used to cover conductive lines or as a bank for following processes. By using fluorinated insulators and fluorinated solvents self assembling structures can be produced very easy. That way patterned ancillary structures can support following patterning methods.

All in all it is a simple and fast one step patterning method to achieve several structures in already coated materials. This method is especially interesting for organic electronics, which can be flexible. Organic devices like OLED displays or OTFT (organic thin film transistor) circuits consist of many different active and inactive components, which have to be produced very cheap. This new technology allows the production of many of these components in a simple way with an improvement of performance and a reduction of the number of process steps.

According to a first aspect of the invention a method for manufacturing a substrate for an electronic device which comprises at least one structured layer of an organic insulating material is disclosed, the method comprising the steps: providing a supporting substrate; applying a continuous layer comprising an organic insulating material on the supporting substrate; and applying an organic solvent directly onto the continuous layer of an organic insulating material. The use of an organic solvent results in a direct patterning method which requires a fewer number of process steps for manufacturing a bank structure for a display device, wherein the bank structure is used for a following inkjet printing process of a dissolved organic electroluminescent material. Preferably the thickness of the organic insulating material of the continuous layer is reduced in a plurality of first areas by applying organic solvent in each of the plurality of first areas wherein no organic solvent is applied onto a second area or onto a plurality of second areas, wherein each second area is defined by an area between adjacent first areas. Preferably each first area is configured to form a pixel area of an organic electroluminescent display and each second area is configured to form a non-pixel area of an organic electroluminescent display. Therefore, a bank structure comprising a plurality of pixel areas can be manufactured by a direct patterning method. The first areas/pixel areas are configured to form mechanical barriers for an ink (to be printed) such that an ink overflow into adjacent pixel areas can be avoided during the manufacture of an OLED display, for example. Therefore, preferably each first area is separated from an adjacent first area by a second area and the thickness of the organic insulating material of the continuous layer in each second area is greater than the thickness of the organic insulating material of the continuous layer in an adjacent first area. Preferably the solvent is applied onto a plurality of first areas arranged in a matrix. Alternatively it is possible that the organic solvent is applied onto a plurality of line-shaped first areas arranged parallel to each other, wherein each of the line-shaped first areas is configured to extend in a horizontal or in a vertical direction of an organic electroluminescent display and wherein each pair of adjacent line-shaped first areas comprises a uniform distance from each other.

The thickness of the insulating layer is reduced in an area onto which the solvent is applied and the thickness of a neighboring area is furthermore increased by the accumulation of dissolved insulating material. Such bank structures can comprise barriers which are up to ten times higher than the pixel areas. Therefore, preferably the organic solvent is applied such that a thickness of the organic insulating material of the continuous layer in each second area is at least two times greater (more preferably five times greater and still more preferably eight times greater) than the thickness of the organic insulating material of the continuous layer in an adjacent first area. The exact reduction of the layer thickness of the continuous layer in the first areas (onto which organic solvent is applied) can be controlled by the following parameters: the material of the continuous insulating layer, the starting thickness of the continuous insulating layer, the solvent material the amount of solvent applied in the first area as well as the surface dimensions of the first area. By the adaptation of the above mentioned parameters it is possible to completely remove the organic insulating material in the first areas or to only reduce the thickness of the organic insulating material in the first areas. By control of the above mentioned parameters the ratio of the thickness of the organic insulating material in the first area and the second area can also be controlled. For the use of a bank structure for the manufacture of an organic electroluminescent display the plurality of first areas is preferably configured such that a pitch (distance between the centers of two adjacent first areas) ranges between 10 µm and 150 µm, more preferably between 30 µm and 80 µm.

According to a second aspect of the invention a method for manufacturing an organic electroluminescent display is disclosed, the method comprising the steps: providing a supporting substrate, applying a first electrode layer onto the supporting substrate, wherein the first electrode layer is preferably an anode layer, applying a continuous layer of an organic insulating material onto the first electrode layer, applying an organic solvent onto a plurality of pixel areas thereby dissolving and completely removing the organic insulating material from the pixel areas such that the first electrode layer is exposed in the pixel areas. Furthermore, an organic electroluminescent layer is applied in each of the pixel areas and a second electrode is applied onto the organic electroluminescent layer. Furthermore, it is preferred that the whole display device is encapsulated in order to prevent moisture and oxygen to deteriorate the organic electroluminescent material. Preferably the active layer consisting of an organic electroluminescent material (electroluminescent layer) is applied onto each of the first electrode layers by inkjet printing or spin coating. Furthermore, it is preferred to apply the organic ectroluminescent material onto the first electrode layer in each of the plurality of pixel areas (first areas) by dipping if fluorinated insulators are used.

According to a third aspect of the invention a method of manufacturing a substrate for an electronic device is disclosed, the method comprising: providing a supporting substrate, applying a continuous layer of an insulating material onto the supporting substrate, applying at least one conductive line onto the continuous layer of an organic insulating material, and applying an organic solvent into at least a portion of an area neighboring the at least one conductive line thereby accumulating the solved insulating material in an edge and/or outer portion of an area onto which the solvent is applied thereby completely covering and encapsulating the at least one conductive line with the dissolved organic insulating material. According to the invention a very easy process for the encapsulation of conductive lines is provided. As already mentioned, the amount of accumulated material which is transported by the application of an organic solvent from an area onto which the solvent is applied to a neighboring area or an edge area can be easily controlled by the selection of the organic insulating material (material and thickness) and the organic solvent (amount of solvent and surface area onto which the solvent is applied). For the encapsulation of a conductive line it is preferred that at least one conductive line is formed with a width between 1 µm and 200 µm and a height between 0.03 µm and 3 µm. More preferably the width of the at least one conductive line ranges between 5 µm and 50 µm and the height ranges between 0.1 µm and 2 µm. Furthermore, preferably the area onto which the organic solvent is applied comprises a distance from the at least one conductive line between 10 µm and 50 µm (more preferably between 20 µm and 40 µm) and extends along a direction which is perpendicular to the longitudinal axis of the at least one conductive line between 50 µm and 500 µm (more preferably between 100 µm and 300 µm). Furthermore, with the method according to the invention it is also possible to encapsulate two or more conductive lines at one time. In order to encapsulate two parallel conductive lines, organic solvent is applied onto an area between the conductive lines. Therefore, according to the invention at least two parallel conductive lines extending along a first direction are formed on the continuous layer of an organic insulating material and the organic solvent is applied in at least a portion of an area between the at least two conductive lines thereby dissolving organic insulating material in an area onto which the organic solvent is applied, and furthermore covering the at least two parallel conductive lines with a dissolved and accumulated insulating material at the same time. Preferably the at least two parallel conductive lines are formed with a width between 10 µm and 50 µm (more preferably between 20 µm and 40 µm) and a height between 0.03 µm and 3 µm (more preferably between 0.1 µm and 2 µm), wherein the distance between adjacent parallel conductive lines ranges between 70 µm and 500 µm (more preferably 100 µm and 400 µm). Furthermore, preferably the area onto which the organic solvent is applied comprises a distance from each of the at least two parallel conductive lines between 10 µm and 50 µm (more preferably between 20 µm and 40 µm) and the area onto which the organic solvent is applied comprises a width extending perpendicular to the axis of the conductive lines between 50 µm and 500 µm (more preferably between 100 µm and 400 µm). Furthermore, it is possible to form additional conductive lines extending along a direction which is different from the direction of the conductive lines which have already been covered with insulting material by the above-described application of an organic solvent. More preferably, the additional conductive lines which are formed over the encapsulated conductive lines have a direction extending perpendicular to the direction of the encapsulated conductive lines.

According to the present invention the formulation "a first layer is applied on a second layer" or "a first layer is arranged on a second layer" or "a first layer is formed on a second layer" or "a first layer is formed above a second layer" is understood such that preferably the first layer is directly arranged on the second layer. However, it is also possible that at least one third layer is present between the first and second layer.

According to a fourth aspect of the invention an array of organic thin film transistors can be easily manufactured by applying an organic solvent onto a continuous layer of an organic insulating material. The method for manufacturing the array comprising a plurality of organic thin film transistors comprises the steps: providing a supporting substrate; applying a plurality of functional layers; each functional layer comprising a source electrode layer, a channel area of semiconducting material and a drain electrode layer; furthermore covering the functional layers with a continuous layer of an organic insulating material. Then for each TFT a gate electrode layer is applied on the continuous layer of an organic insulating material in an area which is located above the channel area of each TFT. Then an organic solvent is applied in a portion neighboring the gate electrode thereby accumulating material in order to encapsulate the gate electrode by dissolving organic insulating material in an area which defines a pixel area for an OLED display. The area in which the organic solvent is applied forms a hollowed or recessed portion which can be used as a pixel portion in an organic electroluminescent display. Preferably the continuous layer of an organic insulating material is formed with a thickness between 0.1 µm and 2 µm (more preferably between 0.5 µm and 1.5 µm) and the at least one gate electrode is formed with a width between 10 µm and 300 µm and a height between 0.3 µm and 3 µm and wherein the distance between the at least one gate electrode and the area in which the organic solvent is applied ranges between 10 µm and 50 µm (more preferably between 20 µm and 40 µm).

According to a fifth aspect of the invention a plurality of thin film transistors, each transistor connected to a pixel electrode layer, are formed on a supporting substrate by forming a plurality of functional layers on the supporting substrate arranged in a matrix, each functional layer comprising: a source electrode layer, a channel area, a drain electrode layer and a pixel electrode layer; wherein the functional layers are covered by the continuous layer and wherein the organic solvent is applied in (first, pixel) areas in which the pixel electrode layers are located thereby (in each pixel) accumulating organic insulating material in an area corresponding to an adjacent source electrode layer and an adjacent drain electrode layer thereby forming a groove in an area corresponding to an adjacent channel area, and wherein a gate electrode is formed in each of the grooves corresponding to the plurality of channel areas. Furthermore, preferably the organic insulating material is dissolved and completely removed in the area onto which the organic solvent is applied thereby forming a plurality of pixel areas. Preferably a passivation layer is formed over each of the plurality of gate electrodes. Preferably the continuous layer is formed having a thickness between 0.1 µm and 2 µm (more preferably between 0.5 µm and 1.5 µm) and the distance between the at least one groove and the adjacent area in which the organic solvent is applied ranges between 50 µm and 500 µm (more preferably between 100 µm and 400 µm).

According to a sixth aspect of the invention a method for manufacturing at least one capacitor is disclosed wherein the capacitance of the capacitor can be increased by controlling the thickness of the insulating layer of the capacitor to very minute dimensions. The method comprises the steps: providing a supporting substrate, applying a first capacitor electrode on the substrate and applying a continuous layer of an organic insulating material on the first capacitor electrode. The continuous layer of the organic insulating material is preferably formed with a thickness between 1 µm and 5 µm. In order to control the thickness of the insulating layer of the capacitor organic solvent is applied onto at least a portion of the (preferably onto the whole) area in which the first capacitor electrode is located thereby reducing the thickness of the organic insulating material. After reducing the thickness of the organic insulating material the second capacitor electrode is formed over the organic insulating material. Preferably the thickness of the material which covers the first capacitor electrode is controlled to a thickness between 50 nm and 1000 nm (more preferably between 50 nm and 500 nm). Preferably the first capacitor electrode and the second capacitor electrode are formed with a length between 50 µm and 500 µm and a width between 50 µm and 500 µm.

According to a seventh aspect of the present invention a plurality of functional layers is formed on the supporting substrate arranged in a matrix, each functional layer comprising: a source electrode layer, a channel area and a drain electrode layer, wherein the functional layers are covered by a continuous layer of an organic insulating material and wherein the organic solvent is applied in areas in which the channel areas are located thereby reducing the thickness of the organic insulating material. Preferably a gate electrode is formed over the organic insulating material in the area of the channel area. Preferably the organic insulating material which covers the channel area is controlled to thickness between 50 nm and 1000 nm (more preferably between 50 nm and 500 nm). Preferably each of the channel areas is formed to comprise a length between 5 nm and 500 µm and a width between 10 µm and 500 µm.

According to an eighth aspect of the present invention a method for manufacturing a pixel defining layer for display applications is provided. The method for manufacturing a plurality of pixel defining layers (preferably arranged in a matrix) comprises the steps: Providing a supporting substrate, applying a first electrode layer onto the supporting substrate, applying a continuous layer of an organic insulating material over the first electrode layer and applying a solvent into a plurality of pixel areas thereby exposing the first electrode layer in the plurality of pixel areas and accumulating organic insulating material in a neighboring area of the plurality of pixel areas thereby forming a pixel defining layer. Preferably the pitch between adjacent pixel areas (the distance between the centers of adjacent pixel areas) ranges between 10 µm and 150 µm (more preferably between 40 µm and 100 µm).

According to a ninth aspect of the invention a method for manufacturing contact holes or via holes or through holes in insulating layers is disclosed. The method for manufacturing a contact hole comprises the steps: providing a supporting substrate, applying a continuous layer of an organic insulating material over the supporting substrate and applying an organic solvent onto an area in which the contact hole shall be formed. In order to reduce the resistance of the contact hole, a plasma etching treatment (preferably using an argon plasma in a microwave plasma device) is provided. The plasma process can be carried out over the whole substrate comprising a plurality of contact holes (preferably arranged in a matrix). The plasma process is carried out for a time of 10 to 120 seconds. The power preferably ranges between 20 and 100 W. The gas flow preferably ranges between 10 and 50s ccm. The electrode distance preferably ranges between 15 and 75 mm. The pressure preferably ranges between 0,01 and 01 mbar. The substrate temperature is preferably room temperature.

The following general remarks apply to the first through ninth aspect of the present invention. Preferably the continuous layer comprising the organic insulating material is completely formed of an organic insulating material. Preferably the continuous layer is formed by spin coating, dip coating, screen printing or off-set printing. Preferably the continuous layer is formed with a thickness between 0.1 µm and 3 µm. Preferably the continuous layer comprises an organic insulating material which comprises a uniform thickness over the whole substrate onto which the continuous layer is applied.

Preferably the organic insulating material is selected from the group consisting of: polyvinylphenol, polyvinylalcohol, polyethylene, polystyrene, poly (methylmethacrylate), poly(butylmethacrylate), poly(cyclohexylmethacrylate), polyisobutylene and polypropylene. Preferably a fluorinated organic polymer is used as the organic insulating material for the continuous layer. Preferably the organic insulating material is selected from the group consisting of: polyhexafluoropropene, fluorinated poly-para-xylene, fluorpolyarylether, fluorpolyalkylether, fluorinated polyamide" fluorinated ehtylene/propylene copolymer, poly-(1,2di-(difluoromethylene)-perfluor-tetrahydrofurane and polytetrafluorethylene.

Preferably the organic solvent is a non-polar solvent. Preferably the organic solvent is selected from the group of: methylenechloride, tetrahydrofurane, xylene, n-hexane, toluene and cyclohexane. Preferably the organic solvent (3) is selected from the group consisting of: anisole, 3,4-dimethylanisole; 1,2 dichlorobenzene; tetraline; 1,2,4trimethylbenzene; 1,2,3trimethylbenzene; 1,3,5trimethylbenzene, methyl benzoate and ethyl benzoate. Preferably the organic solvent (3) is selected from the group consisting of: perfluoroheptane, perfluorooctane, perfluorononane, perfluorodecane, perfluoroundecane, perfluorododecane, perfluorodecaline, perfluoromethyldecaline, perfluoro-dimethylether, perfluoro-tetrahydrofurane, perflouro-methyltetrahydrofurane, perflouro-ethyltetrahydrofurane, perflouro-dipropylether, perflouro-diisopropylether, perfluoro-ethylpropylether, perfluoro-2-butyltetrahydrofurane, perfluorinated saturated tertiary amine, heptacosafluoro-tributylamine and methoxynonafluorobutane.

### BRIEF DESCRIPTION OF THE DRAWINGS

The present invention will now be described by way of example with reference to the accompanying drawings, in which:
- Figure 1: shows a cross-sectional view of a bank structure manufactured according to the present invention,
- Figure 2: illustrates a method of manufacturing a bank structure according to the present invention,
- Figure 3: illustrates a method of manufacturing an organic light-emitting display according to the present invention,
- Figure 4: illustrates a method of encapsulating two parallel conductive lines according to the present invention,
- Figure 5: illustrates a method of manufacturing a plurality of organic thin film transistors connected to a pixel electrode according to the present invention,
- Fig. 6 and 7: illustrate a method of manufacturing an electrophoretic display according to the present invention,
- Figure 8: illustrates another exemplary method of manufacturing a plurality of organic thin film transistors connected to a pixel electrode according to the present invention,
- Figure 9: illustrates a method of manufacturing a capacitor according to the present invention,
- Figure 10: illustrates a method of manufacturing a thin film field effect transistor according to the present invention,
- Figure 11: illustrates a method of manufacturing a pixel defining layer according to the method of the present invention, and
- Figure 12: illustrates a method for manufacturing a plurality of contact holes according to the present invention.

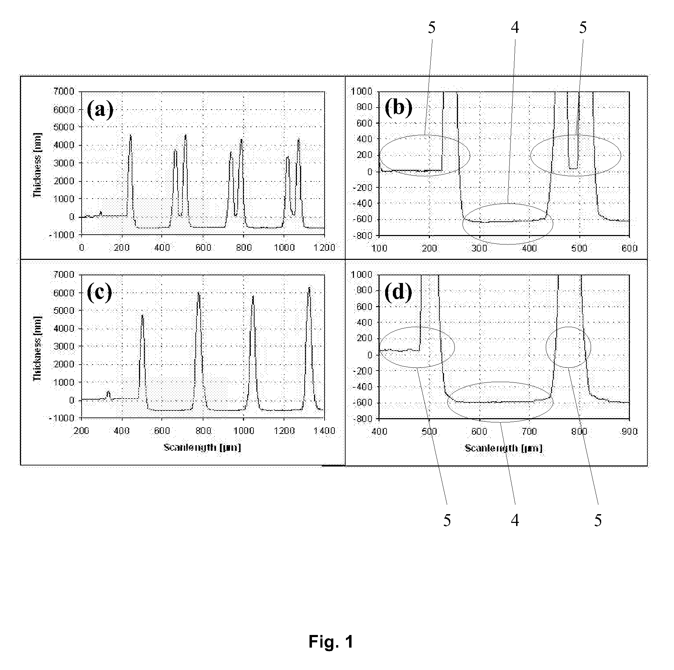

Fig. 1 (a) shows a cross-sectional view of a bank structure which can be used for the manufacture of an organic electroluminescent device. Fig. 1 (b) shows an enlarged view of the bank structure of Fig. 1 (a). In order to obtain a substrate having a bank structure which can be used for an OLED manufacturing process the invention proposes to provide a supporting substrate onto which a continuous layer of an organic insulating material is applied. In order to obtain the bank structure an organic solvent (not shown) is applied onto a plurality of areas 4 which define the pixel area 4 in the OLED manufacturing process. The solvent (not shown) dissolves organic insulating material in the pixel areas 4 and accumulates the dissolved organic insulating material in a periphery area of the pixel area. The periphery 5 of the pixel area 4 is characterized in that no organic solvent is applied onto the non-pixel area 5. According to the amount of the solvent and the distance of the plurality of pixel areas 4 the non-pixel areas 5 can be formed by a single ridge (see Fig. 1(c) or Fig. 1(d)) or by a double ridge (see Fig. 1(a) and Fig. 1(b)). Furthermore, it is possible to form very steep ridges in the non-pixel areas 5 wherein the ridges have a height which can be up to ten times higher than the layer thickness in the pixel areas 4. Furthermore, it is possible to completely remove the organic insulating material from the pixel area 4 or to only reduce (and control) the thickness in the pixel area 4 to a certain amount. The dimension of the horizontal axes is µm and the dimension of the vertical axes is µm through Fig. 1(a) - 1(d).

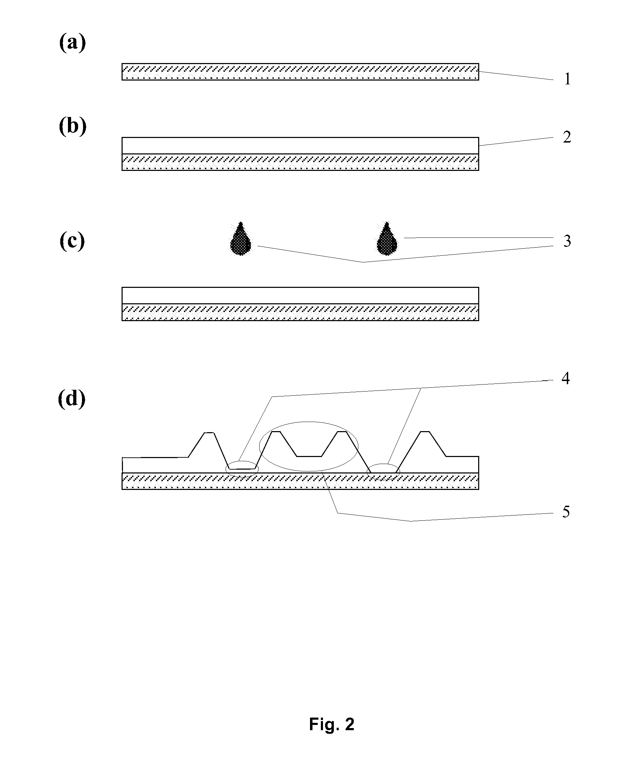

Fig. 2 illustrates a method for manufacturing an organic electroluminescent display according to the present invention. First, a supporting substrate 1 (which is in general preferably formed of a glass or a plastic substrate and which preferably comprises a planar top surface) is provided - see Fig. 2(a). Then, as shown in Fig. 2(b), a continuous layer 2 of an organic insulating material is applied on the substrate 1. Preferably the continuous layer comprises a uniform thickness over the whole substrate. As shown in Fig. 1(c) an organic solvent 3 is applied onto a plurality of pixel areas 4 (see Fig. 1(d)). The solvent dissolves the organic insulating material of the layer 2 and accumulates the dissolved material in an edge portion periphery portion of the area onto which the organic solvent 3 has been applied. As shown in Fig. 2(d) the thickness reduction of the pixel areas corresponds to the amount of the applied solvent 3. As illustrated in the left pixel area 4 the layer thickness has been reduced but the organic insulating material has not been completely removed in the pixel area 4. However, due to the use of a larger amount of the solvent 3 in the right pixel area 4 the organic insulating material has been completely removed. The area between adjacent pixel areas 4 forms a non-pixel area 5 which contains accumulated insulating material. Therefore, the layer thickness of the non-pixel area 5 is increased while the layer thickness of the pixel areas 4 has been decreased.

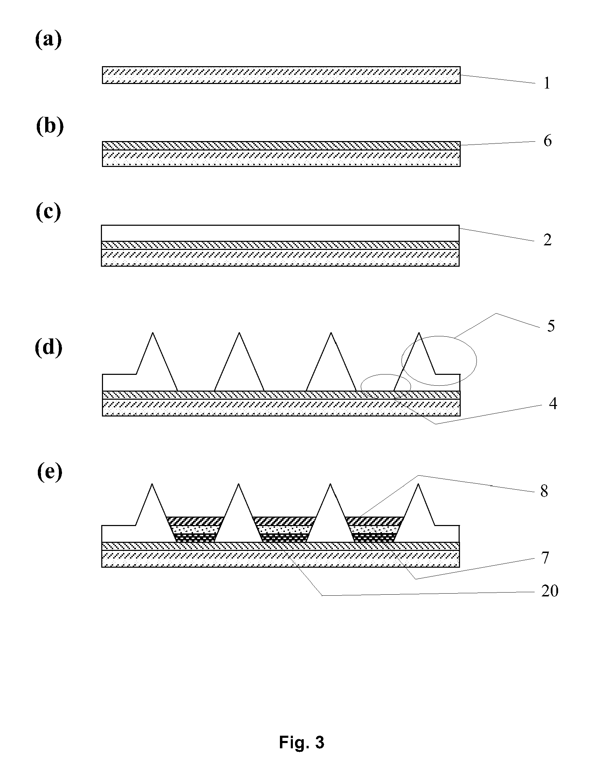

Fig. 3 illustrates a method for manufacturing an organic electroluminescent device according to another exemplary embodiment of the invention. First, a supporting substrate 1 is provided as shown in Fig. 3(a). Then a first electrode layer 6, for example an indium tin oxide (ITO) layer 6 is applied onto the supporting substrate 1 as shown in Fig. 3(b). The first electrode layer 6 is covered by a layer 2 of an organic insulating material as shown Fig. 3(c). Then, organic solvent (not shown) is applied onto a plurality of pixel areas of the organic electroluminescent display. Preferably the organic solvent is applied onto a plurality of pixel areas which are arranged in a matrix. The amount of solvent is controlled such that the organic insulating material is completely dissolved and removed in the pixel areas 4 such as to expose the first electrode layer 6 in each of the plurality of pixel areas 4. In general it shall be noted that reference signs are not attached to every element in every drawing for reasons of clarity but only to an element which is shown the first time. Therefore, it shall be understood that elements having the same hatching represent the same functional elements. As shown in Fig. 3(d) a plurality of non-pixel areas 5 is formed by the accumulation of organic insulating material in said non-pixel areas. According to the present invention the patterning of the bank structure (consisting of the insulating material in the non-pixel areas) can be easily carried out by the steps of applying a continuous layer of organic insulating material and applying a solvent onto the respective areas in which the layer thickness shall be reduced or the layer shall be completely removed. Therefore, cost intensive process steps such as photolithographic processes can be avoided. As shown in Fig. 3(e) the organic electroluminescent device can be finished by the application of an organic electroluminescent layer 7 and a cathode layer 8. Optionally a hole transport layer 20 can be formed between the first electrode layer 6 (which functions as the anode layer) and the organic electroluminescent layer 7.

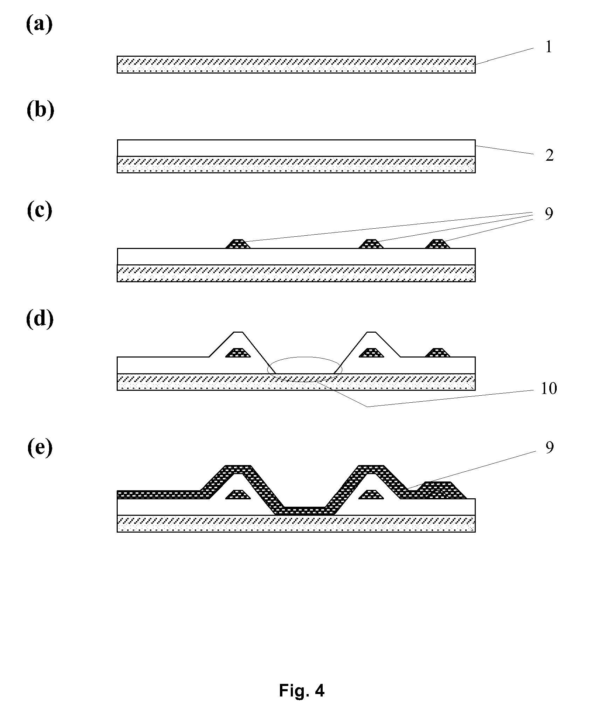

Fig. 4 illustrates a method for encapsulating conductive lines 9 according to the present invention. Display devices, such as OLED devices, include a plurality of conductive lines such as data lines, gate lines and connecting lines between transistors, capacitors and light-emitting diodes. In particular, in the case of crossing conductive lines at least one of the conductive lines has to be encapsulated in order to prevent a short circuit between the at least two conductive lines. According to the present invention a supporting substrate 1 (for a display device) is provided as shown in Fig. 4(a). Then, a continuous layer 2 of an organic insulating material is applied over the substrate 1. As shown in Fig. 4(c) at least one conductive line 9 (in the present case three conductive lines 9) are applied onto the continuous layer 2. In order to encapsulate the left and the middle conductive lines 9 an organic solvent (not shown) is applied in an area between the left and the middle conductive lines 9. The solvent dissolves the organic insulating material in an area between the two conductive lines 9 thereby accumulating the organic insulating material in a periphery portion of the conductive lines 9 thereby encapsulating the left and the middle conductive line 9 with organic insulating material as shown in Fig. 4(d). After the complete encapsulation of the left and the middle conductive line 9 it is further possible to apply a crossing conductive line 9 as shown in Fig. 4 (e). The above-described method is preferably use for the manufacture of an organic electroluminescent display.

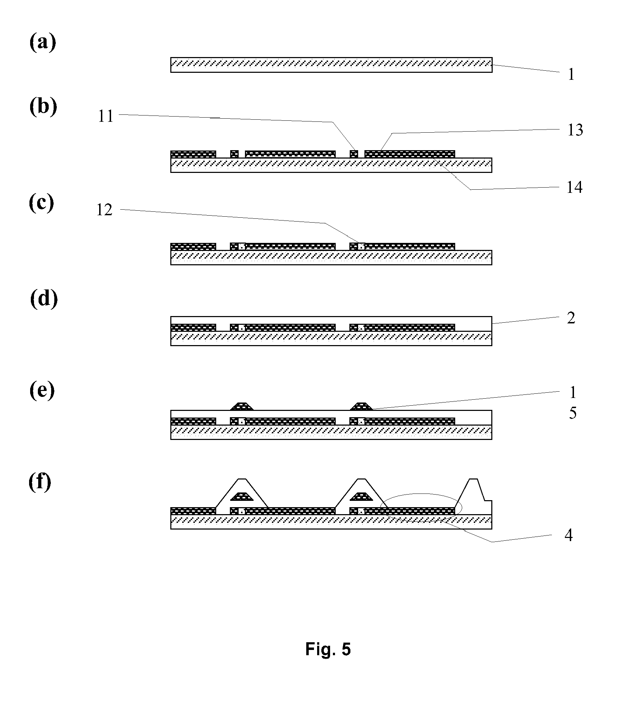

Fig. 5 illustrates a method for manufacturing a plurality of organic thin film transistors which are connected to a plurality of pixel electrodes 14, each OTFT comprising a source electrode 11, a channel area 12 consisting of a semiconducting material, a drain electrode 13, a gate insulating layer 2 and a gate electrode 15. In order to cost effectively manufacture a structure comprising a plurality of OTFTs each connected to a respective pixel electrode 14, a supporting substrate 1 is provided as shown in Fig. 5(a). As shown in Fig. 5(b) and 5(c) a plurality of source electrodes 11, drain electrodes 13, pixel electrodes 14 and channels 12 are formed on the supporting substrate 1. Then, a continuous layer 2 of an organic insulating layer is applied over the whole substrate thereby covering the plurality of source electrodes 11, channels 12, drain electrodes 13 and pixel electrodes 14. Next, as shown in Fig. 5(e) gate electrodes 15 are formed on the insulating layer 2 in an area which is located over the channel area 12 for each OTFT. In order to expose each of the pixel electrode 14 and to encapsulate each of the gate electrodes 15 organic solvent (not shown) is applied onto the plurality of pixel areas 4 defined by the pixel electrodes 14. The solvent dissolves the insulating material in the pixel areas 4 thereby exposing the pixel electrodes 14 and furthermore accumulating the organic material in periphery portions of the pixel portions 4, i.e. in the portions in which the gate electrodes 15 are located thereby encapsulating the gate electrodes 15.

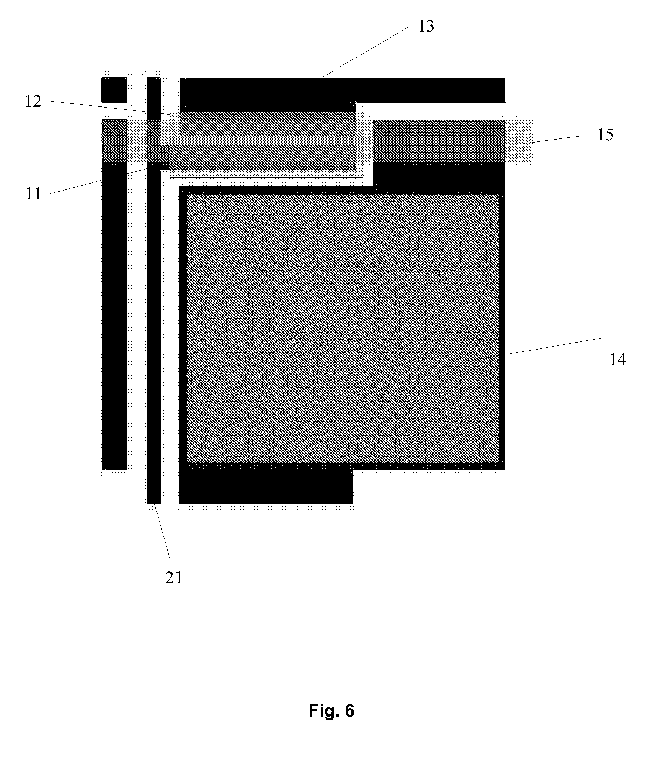

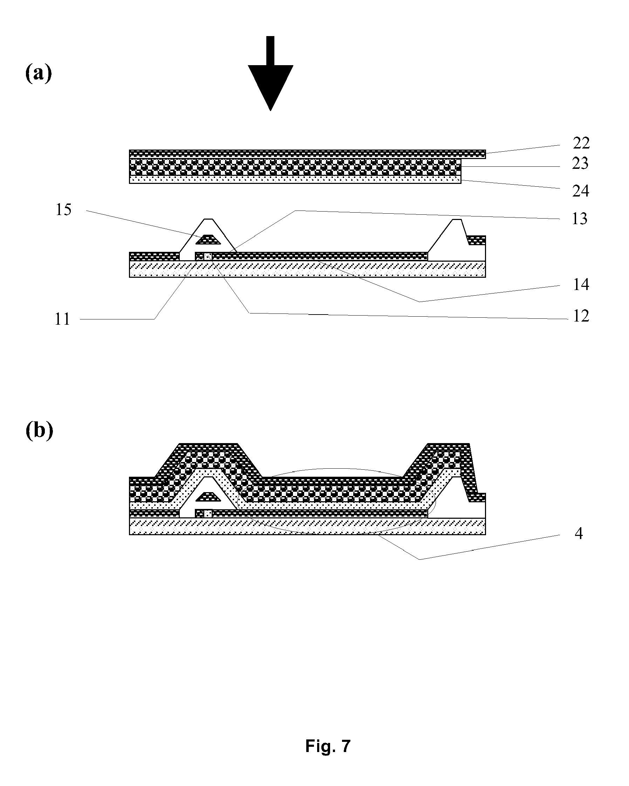

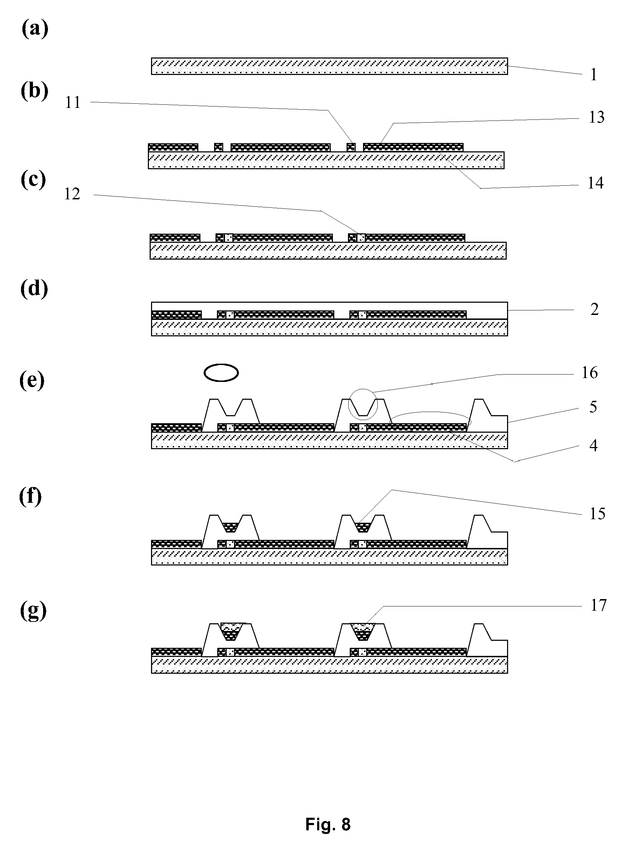

Fig. 6 and 7 illustrate a method for manufacturing an electrophoretic display according to the present invention. As shown in Fig. 6, an electrophoretic display comprises a plurality of pixels arranged in a matrix (only one pixel shown in Fig. 6), wherein each pixel an organic TFT consisting of a source electrode 11, a drain electrode 13, a channel area 12 located between the source electrode 11 and the drain electrodes 13 and a gate electrode 15 which is insulated from the channel area 12 wherein the gate electrode 15 is connected to a select line and the source electrode 11 is connected to a data line wherein the display comprises a plurality of data lines 21, a plurality of select lines 15 intersecting each other thereby defining the plurality of pixels. Furthermore, each pixel comprises a pixel electrode 14 onto which the functional layer of an electrophoretic display are applied during manufacture. In order to obtain an electrophoretic display as shown in Fig. 7(a) a structure comprising a plurality of pixels having one OTFT comprising source 11, channel 12, drain 13 and gate 15 and connected to a pixel electrode 14 are provided. Such a structure can be obtained by the method according to the invention as described in connection with Fig. 5 or as will be described later in connection with Fig. 8. In order to obtain an electrophoretic display a flexible substrate 22 with a second pixel electrode and a layer of an active electrophoretic material 23 and a protection and adhesion layer 24 will be moved downwards to the above mentioned structure. As shown in Fig. 7(b) the electrophoretic display comprises a plurality of pixels, each pixel comprising an OTFT comprising source 11, channel 12, drain 13 and gate 15, wherein the source 11 is connected to one of the plurality of data lines 21 and the gate 15 is connected to one of the plurality of gate lines or select lines and wherein each pixel comprises a pixel area 4 having a pixel electrode 14, a protection and adhesion layer 24, an active electrophoretic material 23, a second pixel electrode 22 which is connected to a flexible substrate.

Fig. 8 illustrates another exemplary embodiment for obtaining a structure comprising a plurality of pixel areas comprising an OTFT connected to a pixel electrode. First as shown in Fig. 8(a)-8(c) a supporting substrate 1 is provided and for each pixel area 4 (see Fig. 8(e)) a source electrode 11, a drain electrode 13, a channel area 12 consisting of semiconducting material will be provided. Next as shown in Fig. 8(d) a continuous layer 2 of an organic insulating material will be applied over the whole substrate and therefore over the plurality of source electrodes 11, channel areas 12 and drain electrodes 13 and pixel electrodes 14. Next, an organic solvent (not shown) is applied onto the plurality of pixel areas 4 thereby exposing the pixel electrodes 14 and the pixel areas 4 and furthermore accumulating organic insulating material in the non-pixel areas in which the plurality of source electrodes 11, channel areas 12 and drain electrodes 13 are located. According to the present embodiment the amount of organic solvent is controlled such that the non-pixel area forms a double ridge structure which comprises a groove 16 in its (inner) middle portion. Next as shown in Fig. 8(f) gate electrodes 15 are applied into the grooves 16. As shown in Fig. 8(g) a passivation layer 17 is applied over the gate electrodes 15. The structure as shown in Fig. 8(g) can be used for further manufacturing process steps for organic electroluminescent displays, electrophoretic displays and the like. The above-described method in preferably used for the manufacture of an OLED display.

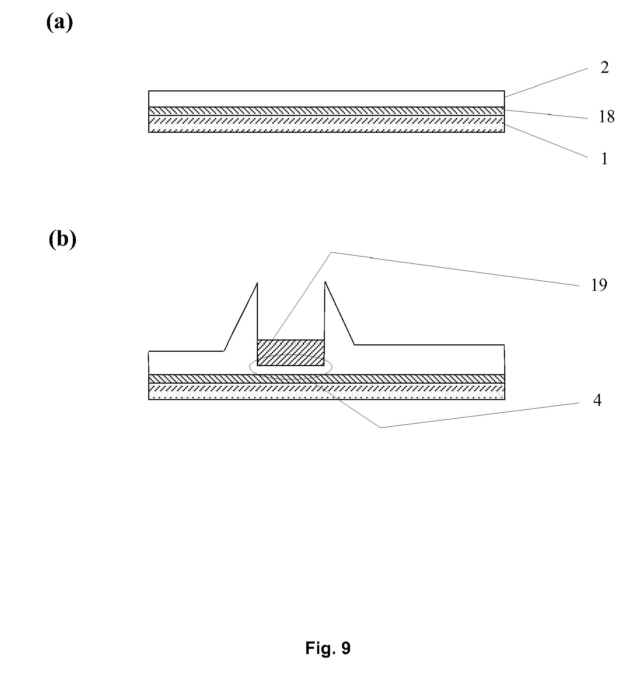

Fig. 9 illustrates a method of manufacturing a capacitor according to the present invention. Usually, for the manufacture of an active matrix organic luminescent display each pixel circuit comprises at least one capacitor. Therefore, a plurality of capacitors has to be manufactured for an organic electroluminescent display. In order to obtain a large capacitance it is necessary to form a very thin insulating layer between the two capacitor electrodes. However, according to conventional methods for applying insulating layers it is difficult to control the layer thickness to very small amounts. Therefore, according to the present invention the layer thickness of an insulating layer can be reduced and controlled to a desired amount by use of an organic solvent. As shown in Fig. 9(a) a supporting substrate 1 comprising a first capacitor electrode 18 is provided. Then, a continuous layer of an organic insulating material is applied over the first capacitor electrode 18. In order to reduce the layer thickness of the insulating layer 2 an organic solvent (not shown) is applied on the continuous layer 2 thereby reducing and controlling the layer thickness to a certain amount. Next as shown in Fig. 9(b) the second capacitor electrode 19 is applied thereby forming a capacitor. Such capacitors are preferably used for the manufacture of an active matrix organic electroluminescent display.

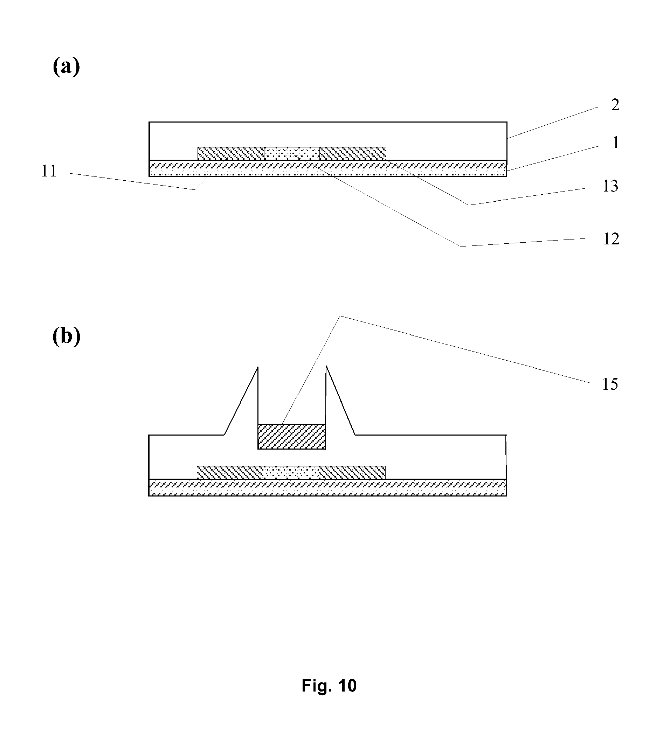

Furthermore, for the manufacture of an active matrix organic electroluminescent display a plurality of thin film transistors has to be manufactured for each pixel. In order to obtain a uniform brightness over the whole display it is necessary to form a plurality of organic thin film transistors having uniform electric characteristics. Therefore, it is also necessary to apply gate electrodes with an uniform distance from the active area (insulated by a gate insulating layer) over the whole substrate. According to the present invention as shown in Fig. 10(a) a supporting substrate 1 is provided, the supporting substrate 1 comprising a source electrode 11, a channel area 12 consisting of a semiconducting material and a drain electrode 13. The said structure is then covered with a continuous layer 2 of an organic semiconducting material. The layer thickness of the organic insulating material is more than 1 µm. Next an organic solvent (not shown) is applied on the layer 2 in an area which is located above the channel area 12 thereby reducing and controlling the layer thickness to a desired amount of less than 1 µm. Next as shown in Fig. 10(b) the gate electrode 15 is applied onto the hollowed portion of the layer 2 in an area which is located above the channel area 12. The above described method for the manufacture of an organic thin film transistor is preferably used for the manufacture of an organic electroluminescent display.

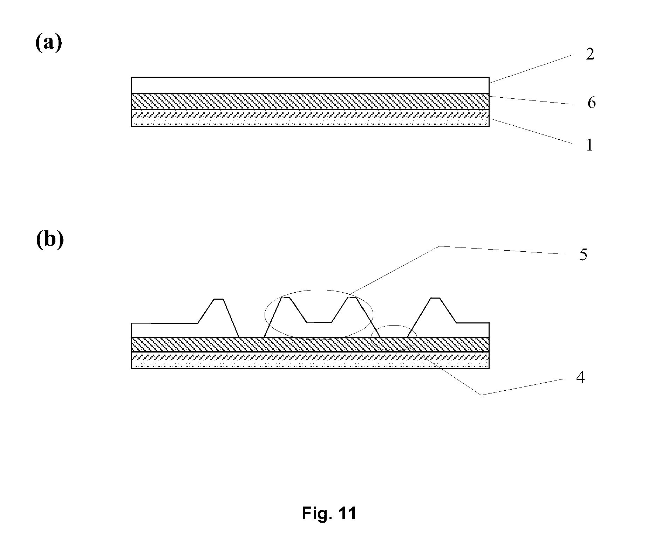

Fig. 11 illustrates a method for forming a pixel defining layer according to the present invention. During the manufacture of active matrix organic electroluminescent displays is usually desirable to form pixel defining layers. According to the present invention the method of forming pixel defining layers comprises: providing a supporting substrate 1 onto which a first electrode layer 6 is applied. Then a continuous layer 2 of an organic insulating material is applied directly over the first electrode layer as shown in Fig. 11 (a). Next, an organic solvent (not shown) is applied onto the plurality of pixel areas 4 of the organic electroluminescent display. As shown in Fig. 11 (b) the organic solvent dissolves the organic insulating material in the pixel areas 4 thereby exposing the first pixel electrode layer 6 and accumulates the organic insulating material in the non-pixel areas 5. The above described method of forming a pixel defining layer is preferably used for the manufacture of an organic electroluminescent display. In general, an organic electroluminescent display comprises a plurality of pixels arranged in a matrix, each pixel comprising at least one organic thin film transistor wherein a source of the organic thin film transistor is connected to a data line and a gate of the organic thin film transistor is connector to a select line of the organic electroluminescent display and wherein the drain of the thin film transistor is connected to a first pixel electrode and each pixel furthermore comprises an organic electroluminescent active layer as well as a second electrode. As mentioned above each pixel may further comprise a pixel defining layer and furthermore it may be necessary to arrange contact holes into insulating layers, for example to connect the drain electrode with the first pixel electrode.

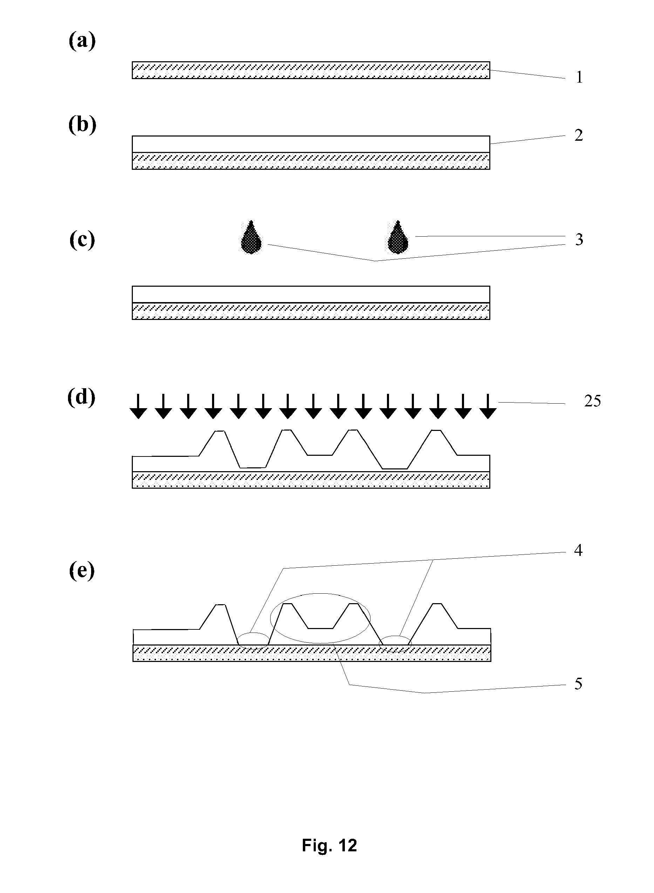

Fig. 12 illustrates a method for manufacturing a contact hole according to the present invention. The supporting substrate 1 which can preferably consist of glass or plastic is provided and a continuous layer 2 of an organic insulating material is applied over the whole substrate 1. Next as shown in Fig. 12(c) an organic solvent 3 is applied on the continuous layer 2 onto an area in which a contact hole/via hole shall be formed. As shown in Fig. 12(d) the organic insulating material is sometimes not perfectly removed in the area where the contact hole shall be formed because small amounts of organic insulating material remain in the contact holes. In order to decrease the resistance of the contact hole the present invention furthermore provides a step of carrying out a plasma-etching process 25 as shown in Fig. 12(d). Therefore, the organic insulating material is completely removed in the first area 4.

### List of reference signs

- 1.: supporting substrate
- 2.: continuous layer of an organic insulating material
- 3.: organic solvent
- 4.: first area / pixel area
- 5.: second area / non pixel area
- 6.: first electrode layer / (ITO)
- 7.: organic electroluminescent layer
- 8.: second electrode layer
- 9.: conductive line
- 10.: adjacent area of the conductive line
- 11.: source electrode layer
- 12.: channel area / semiconducting layer
- 13.: drain electrode layer
- 14.: pixel electrode layer
- 15.: gate electrode / Vselect
- 16.: groove
- 17.: passivation layer
- 18.: first capacitor electrode
- 19.: second capacitor electrode
- 20.: hole transport layer
- 21.: Vdata
- 22.: flexible substrate with second pixel electrode
- 23.: layer of active electrophoretic material
- 24.: protection and adhesion layer
- 25.: plasma etch process

## Claims

1. A method for manufacturing a substrate for an electronic device comprising at least one structured layer comprising an organic insulating material, the method comprising the following steps:
- providing a supporting substrate (1);
- applying a continuous layer (2) comprising an organic insulating material on the supporting substrate (1); and
- applying an organic solvent (3) directly on the continuous layer (2) of an organic insulating material.

2. The method of claim 1,
wherein the thickness of the organic insulating material of the continuous layer (2) is reduced in a plurality of first areas (4) by applying organic solvent (3) in each of the the plurality of first areas (4) wherein no organic solvent (3) is applied onto second areas (5), wherein each second area (5) is defined by an area between adjacent first areas (4).

3. The method of claim 2,
wherein each first area (4) is configured to form a pixel area of an organic electroluminescent display and each second area (5) is configured to form a non pixel area of an organic electroluminescent display.

4. The method according to one of the claims 2 and 3,
wherein each first area (4) is separated from an adjacent first area (4) by a second area (5), and wherein the thickness of the organic insulating material of the continuous layer (2) in each second area (5) is greater than the thickness of the organic insulating material of the continuous layer (2) in an adjacent first area (4).

5. The method according to one of the preceding claims,
wherein the solvent (3) is applied onto a plurality of first areas (4) arranged in a matrix shape.

6. The method according to one of the claims 1-5,
wherein the organic solvent (3) is applied onto a plurality of line-shaped first areas (4) arranged parallel to each other, wherein each of the line-shaped first areas (4) is configured to extend in a horizontal or in vertical direction of an organic electroluminescent display and wherein each pair of adjacent line-shaped first areas (4) comprises a unifrom distance from each other.

7. The method according to one of the preceding claims,
wherein the organic solvent (3) is applied such that the thickness of the organic insulating material of the continuous layer (2) in each second area (5) is at least 2 times greater than the thickness of the organic insulating material of the continuous layer (2) in an adjacent first area (4).

8. The method according to one of the preceding claims,
wherein the organic solvent (3) is applied such that the thickness of the organic insulating material of the continuous layer (2) in each second area (5) is at least 5 times greater than the thickness of the organic insulating material of the continuous layer (2) in an adjacent first area (4).

9. The method according to one of the preceding claims,
wherein the plurality of first areas (4) is configured such that a pitch between adjacent first areas (4) ranges between 10 µm and 150 µm.

10. The method of claim 1, wherein a substrate having an organic electroluminescent display device is manufactured, comprising:
- prior to the step of applying a continuous layer (2) a first electrode layer (6) is applied onto the supporting substrate (1) and the continuous layer (2) is applied onto the first electrode layer (6), and wherein the organic solvent (3) is applied on the continuous layer (2) such that the organic insulating material is completely removed in an area onto which the organic solvent (3) is applied,
- applying an active layer (7) of organic electroluminescent material onto each of the first electrode layers (6),
- applying a second electrode layer (8) onto each of the active layers (7).

11. The method of claim 10,
wherein the active layer (7) of organic electroluminescent material is applied onto each of the first electrode layers (6) by ink jet printing, spin coating or dipping.

12. The method of claim 1,
wherein prior to the step of applying the organic solvent (3) at least one conductive line (9) extending along a first direction is formed on the continuous layer (2) of an organic insulating material and wherein the organic solvent (3) is applied in at least a portion of an area (10) adjacent to the at least one conductive line (9) thereby covering the at least one conductive line (9) with organic insulating material.

13. The method of claim 12,
wherein the at least one conductive line (9) is formed with a width between 1µm and 200µm and a hight between 0,03µm and 3µm.

14. The method of one of claims 12 and 13,
wherein the area (10) into which the organic solvent (3) is applied comprises a distance from the at least one conductive line (9) between 10µm and 50µm and extends along a direction which is perpendicular to the first direction between 50µm and 500µm.

15. The method of claim 1,
wherein prior to the step of applying the organic solvent (3) at least two parallel conductive lines (9) extending along a first direction are formed on the continuous layer (2) of an organic insulating material and wherein the organic solvent (3) is applied in at least a portion of an area (10) between the at least two conductive lines (9) thereby covering the at least two parallel conductive lines (9) with organic insulating material.

16. The method of claim 15,
wherein the at least two parallel conductive lines (9) are formed with a width between 10µm and 50µm, a hight between 0,03µm and 3µm, and wherein the distance between adjacent parallel conductive lines (9) ranges between 70µm and 500µm.

17. The method of one of claims 15 and 16,
wherein the area (10) into which the organic solvent (3) is applied comprises a distance from each of the parallel conductive line (9) between 10µm and 50µm and the area (10) comprises a width extending along a direction which is perpendicular to the first direction between 50µm and 500µm.

18. The method according to one of the claims 12-17,
wherein at least one additional conductive line (9) extending along a second direction is formed over the at least one covered conductive line (9) extending along a first direction, the first direction being different from the second direction.

19. The method of claim 1,
wherein prior to the step of applying the continuous layer (2) at least one source electrode layer (11), at least one channel area (12), at least one drain electrode layer (13) and at least one pixel electrode layer (14) are applied,
wherein the source electrode layer (11), the channel area (12), the drain electrode layer (13) and the pixel electrode layer (14) are covered by the continuous layer (2),
and wherein prior to the step of applying the organic solvent (3) at least one gate electrode (15) is formed on the continuous layer (2) in an area which is located above the channel area (12), and
wherein the organic solvent (3) is applied in at least a portion of the area in which the pixel electrode layer (14) is located thereby covering the at least one gate electrode (15) which is located adjacent to the at least one pixel electrode layer (14) with organic insulating material and furthermore removing the organic insulating material from the pixel electrode layer (14).

20. The method of claim 19,
wherein a plurality of thin film transistors (11, 12, 13, 15) each connected to a pixel electrode layer (14) are formed on the substrate by forming a pluraliy of functional layers (11, 12, 13, 14) on the supporting substrate (1) arranged in a matrix, each functional layer (11, 12, 13, 14) comprising a source electrode layer (11), a channel layer (12), a drain electrode layer (13) and pixel electrode layer (14), wherein the functional layers (11, 12, 13, 14) are covered by the continuous layer (2),
and wherein prior to the step of applying the organic solvent (3) a plurality of gate electrodes (15) are formed on the continuous layer (2) corresponding to the plurality of channel layers (12), and
wherein the organic solvent (3) is applied in areas in which the pixel electrode layers (14) are located thereby covering adjacent one gate electrodes (15) with organic insulating material and furthermore removing the organic insulating material from the plurality of pixel electrode layers (14).

21. The method according to one of the claims 19 and 20,
wherein the continuous layer (2) is formed with a thickness between 0,1µm and 2µm, the at least one gate electrode (15) is formed with a width between 10µm and 300µm, a hight between 0,03µm and 3µm, and wherein the distance between the at least one gate electrode (15) and the area in which the organic solvent (3) is applied ranges between 10µm and 50µm.

22. The method of claim 1,
wherein a plurality of thin film transistors (11, 12, 13, 15) each connected to a pixel electrode layer (14) are formed on the substrate by forming a pluraliy of functional layers (11, 12, 13, 14) on the supporting substrate (1) arranged in a matrix, each functional layer (11, 12, 13, 14) comprising a source electrode layer (11), a channel area (12), a drain electrode layer (13) and a pixel electrode layer (14), wherein the functional layers (11, 12, 13, 14) are covered by the continuous layer (2), and
wherein the organic solvent (3) is applied in areas in which the pixel electrode layers (14) are located thereby accumulating organic insulating material in an area corresponding to an adjacent source electrode layer (11) and an adjacent drain electrode layer (13) thereby forming a groove (16) in an area corresponding to an adjacent channel area (12), and wherein gate electrodes (15) are formed in each of the grooves (16) corresponding to the plurality of channel areas (12).

23. The method of claim 22,
wherein a passivation layer (17) is formed over each of the plurality of gate electrodes (15).

24. The method according to one of the claims 22 and 23,
wherein the continuous layer (2) is formed with a thickness between 0,1µm and 2µm, and wherein the distance between the at least one groove (16) and the area in which the organic solvent (3) is applied ranges between 50µm and 500µm.

25. The method of claim 1,
wherein prior to the step of applying the continuous layer (2) at least one first capacitor electrode (18) is formed on the supporting substrate (1), wherein after the step of applying the continuous layer (2) the organic solvent (3) is applied in at least a portion of the area in which the first capacitor electrode (18) is located thereby reducing the thickness of organic insulating material.

26. The method of claim 25,
wherein a second capacitor electrode (19) is formed over the organic insulating material.

27. The method according to one of the claims 25 and 26,
wherein the organic insulating material which covers the first capacitor electrode (18) is controlled to a thickness between 50nm and 1000nm.

28. The method according to one of the claims 25 - 27,
wherein the first capacitor electrode (18) and the second capacitor electrode (19) are formed having a length between 50µm and 500µm and having a width between 50µm and 500µm.

29. The method of claim 1,
wherein prior to the step of applying the continuous layer (2) a pluraliy of functional layers (11, 12, 13) is formed on the supporting substrate (1) arranged in a matrix, each functional layer (11, 12, 13) comprising a source electrode layer (11), a channel area (12) and a drain electrode layer (13),
wherein the functional layers (11, 12, 13, 14) are covered by the continuous layer (2), and wherein the organic solvent (3) is applied in areas in which the channel areas (12) are located thereby reducing the thickness of organic insulating material.

30. The method of claim 29,
wherein a gate electrode (15) is formed over the organic insulating material in the area of the channel area (12).

31. The method according to one of the claims 29 and 28,
wherein the organic insulating material which covers the channel area (12) is controlled to a thickness between 50nm and 1000nm.

32. The method according to one of the claims 29 - 31,
wherein the channel area (12) is formed having a length between 5nm and 500µm and having a width between 0,5µm and 500µm.

33. The method according to one of claims 2-5,
wherein prior to the step of applying a continuous layer (2) a first electrode layer (6) is applied onto the supporting substrate (1) and the continuous layer (2) having a thickness between 5nm and 3µm is applied onto the first electrode layer (6), and wherein the organic solvent (3) is applied on the continuous layer (2) in a plurality of first areas (4) such that the organic insulating material is completely removed in an area onto which the organic solvent (3) is applied and the first electrode layer (6) is exposed in the plurality of first areas (4), wherein a pitch between adjacent first areas (4) ranges between 50 µm and 500 µm.

34. The method according to claim 1,
the organic solvent (3) is applied on the continuous layer (2) such that the organic insulating material is completely removed in an area onto which the organic solvent (3) is applied and the layer which is underlying the continuous layer (2) is exposed in the area onto which the organic solvent (3) is applied, wherein the exposed area of the underlying layer is furthermore treated by plasma etching.

35. The method according to one of the preceding claims,
wherein the continuous layer (2) is completely formed of an organic insulating material.

36. The method according to one of the preceding claims,
wherein the continuous layer (2) is formed by spin coating, dip coating, screen printing or offset printing.

37. The method according to one of the preceding claims,
wherein the continuous layer (2) is formed with a thickness between 0,1µm and 3µm.

38. The method according to one of the preceding claims,
wherein the continuous layer (2) comprising an organic insulating material comprises a uniform thickness.

39. The method according to one of the preceding claims,
wherein the organic insulating material is selected from the group consisting of: polyvinylphenol, polyvinylalcohol, polyethylene, polystyrene, poly (methylmethacrylate), poly(butylmethacrylate), poly(cyclohexylmethacrylate), polyisobutylene and polypropylene.

40. The method according to one of the preceding claims,
wherein a fluorinated organic polymer is used as the organic insulating material for the continuous layer (2).

41. The method according to one of the claim 40,
wherein the organic insulating material is selected from the group consisting of: polyhexafluoropropene, fluorinated poly-para-xylene, fluoropolyarylether, fluoropolyalkylether, fluorinated polyamide, , fluorinated ehtylene/propylene copolymer, poly-(1,2di- (difluoromethylene)-perfluor-tetrahydrofurane) and polytetrafluoroethylene.

42. The method according to one of the preceding claims,
wherein the organic solvent (3) is a non-polar solvent.

43. The method according to one of the preceding claims,
wherein the organic solvent (3) is selected from the group of: methylenechloride,
tetrahydrofurane, xylene, n-hexane, toluene and cyclohexane.

44. The method according to one of the claims 1-42,
wherein the organic solvent (3) is selected from the group consisting of: anisole, 3,4-dimethylanisole; 1,2 dichlorobenzene; tetraline; 1,2,4trimethylbenzene; 1,2,3trimethlbenzene; 1,3,5trimethlbenzene, methyl benzoate and ethyl benzoate.

45. The method according to one of the claims 40-41,
wherein the organic solvent (3) is selected from the group consisting of: perfluoro-heptane, perfluoro-octane, perfluoro-nonane, perfluoro-decane, perfluoro-undecane, perfluoro-dodecane, perfluoro-decaline, perfluoromethyldecaline, perfluoro-ether, perfluoro-tetrahydrofurane, perflouro-2-methyltetrahydrofurane, perflouro-2-ethyltetrahydrofurane, perflouro-dipropylether, perflouro-diisopropylether, perfluoro-ethylpropylether, perfluoro-2-butyltetrahydrofurane, perfluorinated saturated tertiary amine and heptacosafluoro-tributylamine.

## Amended claims

### Amended claims in accordance with Rule 137(2) EPC.

**1.** A method for manufacturing a substrate for an electronic device comprising at least one structured layer comprising an organic insulating material, the method comprising the following steps:
- providing a supporting substrate (1);
- applying a first electrode layer (6) onto the supporting substrate (1);
- applying a continuous layer (2) comprising an organic insulating material onto the first electrode layer (6);
- applying an organic solvent (3) directly on a plurality of first areas (4) of the continuous layer (2) such that the organic insulating material is completely removed in the first areas (4) onto which the organic solvent (3) is applied,wherein no organic solvent (3) is applied onto second areas (5), and wherein each second area (5) is defined by an area between adj acent first areas (4);
- applying an active layer (7) of organic electroluminescent material onto each of the exposed areas of the first electrode layer (6),
- applying a second electrode layer (8) onto each of the active layers (7).

**2.** The method of claim 1,
wherein each first area (4) is configured to form a pixel area of an organic electroluminescent display and each second area (5) is configured to form a non pixel area of an organic electroluminescent display.

**3.** The method according to one of the claims 1 and 2,
wherein each first area (4) is separated from an adjacent first area (4) by a second area (5), and wherein the thickness of the organic insulating material of the continuous layer (2) in each second area (5) is greater than the thickness of the organic insulating material of the continuous layer (2) in an adjacent first area (4).

**4.** The method according to one of the preceding claims,
wherein the solvent (3) is applied onto a plurality of first areas (4) arranged in a matrix shape.

**5.** The method according to one of the claims 1-4,
wherein the organic solvent (3) is applied onto a plurality of line-shaped first areas (4) arranged parallel to each other, wherein each of the line-shaped first areas (4) is configured to extend in a horizontal or in vertical direction of an organic electroluminescent display and wherein each pair of adjacent line-shaped first areas (4) comprises a unifrom distance from each other.

**6.** The method according to one of the preceding claims,
wherein the organic solvent (3) is applied such that the thickness of the organic insulating material of the continuous layer (2) in each second area (5) is at least 2 times greater than the thickness of the organic insulating material of the continuous layer (2) in an adjacent first area (4).

**7.** The method according to one of the preceding claims,
wherein the organic solvent (3) is applied such that the thickness of the organic insulating material of the continuous layer (2) in each second area (5) is at least 5 times greater than the thickness of the organic insulating material of the continuous layer (2) in an adjacent first area (4).

**8.** The method according to one of the preceding claims,
wherein the plurality of first areas (4) is configured such that a pitch between adjacent first areas (4) ranges between 10 µm and 150 µm.

**9.** The method of claim 1,
wherein the active layer (7) of organic electroluminescent material is applied onto each of the first electrode layers (6) by ink jet printing, spin coating or dipping.

**10.** The method according to one of the preceding claims,
wherein the continuous layer (2) is completely formed of an organic insulating material.

**11.** The method according to one of the preceding claims,
wherein the continuous layer (2) is formed by spin coating, dip coating, screen printing or offset printing.

**12.** The method according to one of the preceding claims,
wherein the continuous layer (2) is formed with a thickness between 0,1 µm and 3 µm.

**13.** The method according to one of the preceding claims,
wherein the continuous layer (2) comprising an organic insulating material comprises a uniform thickness.

**14.** The method according to one of the preceding claims,
wherein the organic insulating material is selected from the group consisting of: polyvinylphenol, polyvinylalcohol, polyethylene, polystyrene, poly (methylmethacrylate), poly(butylmethacrylate), poly(cyclohexylmethacrylate), polyisobutylene and polypropylene.

**15.** The method according to one of the preceding claims,
wherein a fluorinated organic polymer is used as the organic insulating material for the continuous layer (2).

**16.** The method according to claim 15,
wherein the organic insulating material is selected from the group consisting of: polyhexafluoropropene, fluorinated poly-para-xylene, fluoropolyarylether, fluoropolyalkylether, fluorinated polyamide, , fluorinated ehtylene/propylene copolymer, poly-(1,2di- (difluoromethylene)-perfluor-tetrahydrofurane) and polytetrafluoroethylene..

**17.** The method according to one of the preceding claims,
wherein the organic solvent (3) is a non-polar solvent.

**18.** The method according to one of the preceding claims,
wherein the organic solvent (3) is selected from the group of:
methylenechloride,
tetrahydrofurane, xylene, n-hexane, toluene and cyclohexane.

**19.** The method according to one of the claims 1-17,
wherein the organic solvent (3) is selected from the group consisting of:
anisole, 3,4-dimethylanisole; 1,2 dichlorobenzene; tetraline;
1,2,4trimethylbenzene; 1,2,3trimethlbenzene; 1,3,5trimethlbenzene, methyl benzoate and ethyl benzoate.

**20.** The method according to one of the claims 15 -16,
wherein the organic solvent (3) is selected from the group consisting of:
perfluoro-heptane, perfluoro-octane, perfluoro-nonane, perfluoro-decane, perfluoro-undecane, perfluoro-dodecane, perfluoro-decaline, perfluoro-methyldecaline, perfluoro-ether, perfluoro-tetrahydrofurane, perflouro-2-methyltetrahydrofurane, perflouro-2-ethyltetrahydrofurane, perflouro-dipropylether, perflouro-diisopropylether, perfluoro-ethylpropylether, perfluoro-2-butyltetrahydrofurane, perfluorinated saturated tertiary amine and heptacosafluoro-tributylamine.
